# EUROPEAN PATENT SPECIFICATION

(11) **EP 3 713 817 B1**
(45) Date of publication and mention of the grant of the patent: **11.01.2023**
(21) Application number: 18880584.0
(22) Date of filing: 23.11.2018
(51) Int. Cl.: B62D 25/00, B32B 3/26, B32B 5/02, B60R 16/03, B60R 16/033, B62D 25/06, B62D 63/08, H02S 20/00, H02S 30/00, B32B 1/00

(54) **LAMINATE STRUCTURAL PANEL FOR VEHICLE WITH INTEGRATED SOLAR POWER GENERATION**
LAMINIERTE BAUPLATTE FÜR FAHRZEUG MIT INTEGRIERTER SOLARENERGIEERZEUGUNG
PANNEAU STRUCTURAL STRATIFIÉ POUR VÉHICULE À GÉNÉRATION D'ÉNERGIE SOLAIRE INTÉGRÉE

(30) Priority: 23.11.2017 US 201762590318 P; 14.09.2018 US 201862731348 P
(43) Date of publication of application: 30.09.2020
(73) Proprietor: Westhill Innovation Inc., Simcoe, Ontario N3Y 4L1 (CA)
(72) Inventor: SHERWOOD, Vernon Douglas Steven, Dundas, Ontario L9H 4V3 (CA); SUCCI, Gina, Simcoe, Ontario N3Y 4L1 (CA); ALAISOWI, Mohammad Hussein, Mississauga, Ontario (CA)
(74) Representative: Lawrie IP Limited
(86) International application number: PCT/IB2018/059269
(87) International publication number: WO 2019/102419

(56) References cited:
- WO-A1-2009/150639
- WO-A1-2011/055355
- WO-A1-2011/055355
- WO-A1-2012/120489
- WO-A1-2013/046195
- WO-A1-2014/086552
- WO-A1-2014/086552
- CA-A1- 2 723 574
- US-A1- 2002 112 419
- US-A1- 2007 074 755
- US-A1- 2014 157 693
- US-B2- 7 713 089

## Description

### CROSS-REFERENCE TO RELATED APPLICATIONS

This application claims priority from U.S. Provisional Patent Application Nos. 62/590318, filed November 23, 2017, and 62/731348, filed September 14, 2018.

### FIELD

The specification relates generally to structural laminates, and specifically to composite vehicle panels with integrated solar power generation.

### BACKGROUND

Vehicles, such as semi-trailers, typically include various onboard devices requiring electrical power to operate. Such devices are generally powered by the primary powerplant of the vehicle, increasing fuel consumption. Implementing other power generation technologies may increase the weight, complexity, cost, or a combination thereof of the vehicle sufficiently to negate any advantages gained in fuel consumption.

US 2014/157693A1 relates to a solar module, a method for producing a solar module, and the use of a solar module on a flat roof, preferably on a metal flat roof of a building or a vehicle for transportation on water, on land, or in the air.

### SUMMARY

An aspect of the specification provides a laminate panel for a vehicle including: a core member formed from a core material including a fiber and a binder, the core member having: (i) a perimeter separating opposing upper and lower surfaces of the core member; (ii) a channel defined in the core material between an upper channel outlet at the upper surface, and a lower channel outlet; an upper reinforcing skin member affixed to the upper surface of the core member and defining an opening in communication with the upper channel outlet; a flexible solar module affixed to the upper reinforcing skin member; a lower reinforcing skin member affixed to the lower surface of the core member; and an electrical conduit extending from the flexible solar module to the lower channel outlet via the opening, the upper channel outlet and the channel.

Another aspect of the specification provides a vehicle-mounted system for power generation, comprising: at least one laminate panel including: a core member formed from a core material including a fiber and a binder, the core member having: (i) a perimeter separating opposing upper and lower surfaces of the core member; (ii) a channel defined in the core material between an upper channel outlet at the upper surface, and a lower channel outlet; an upper reinforcing skin member affixed to the upper surface of the core member and defining an opening in communication with the upper channel outlet; a flexible solar module affixed to the upper reinforcing skin member; and a lower reinforcing skin member affixed to the lower surface of the core member; a power management assembly; and an electrical conduit connecting the flexible solar module to the power management assembly via the opening, the upper channel outlet, the channel and the lower channel outlet.

### BRIEF DESCRIPTIONS OF THE DRAWINGS

Embodiments are described with reference to the following figures, in which:
FIG. 1 depicts a vehicle including panels with integrated solar power generation;
FIG. 2A depicts a panel of the vehicle of FIG. 1;
FIG. 2B depicts an exploded view of the panel of FIG. 2A;
FIG. 3 depicts a further exploded view of the panel of FIG. 2A;
FIG. 4A depicts a cross-sectional view taken at the line A-A of FIG. 3;
FIG. 4B depicts the cross-sectional view of FIG. 4A, according to another embodiment;
FIG. 4C depicts a side view of the panel of FIG. 2A;
FIG. 5 depicts an overhead view of a set of the panels of FIG. 2A;
FIG. 6 depicts a further vehicle including a panel with integrated solar power generation;
FIG. 7 depicts an underside of the panel of the vehicle in FIG. 6;
FIG. 8 is a block diagram of a power management assembly of the vehicle of FIG. 1.

### DETAILED DESCRIPTION

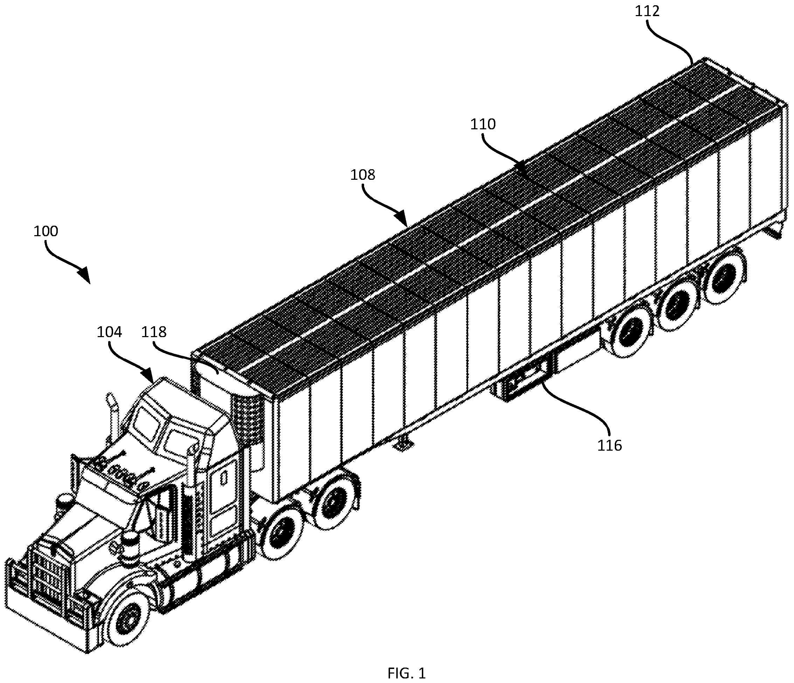

FIG. 1 depicts a vehicle 100, which in the present example is a semi-trailer including a tractor unit 104 and a semi-trailer 108. The semi-trailer 108, as will be apparent to those skilled in the art, provides a container for freight, defined by a floor and wall panels, as well as by a roof 110. The roof 110 is constructed from a plurality of roof panels 112 bearing solar modules for capturing sunlight and generating electrical power. In the present example, the roof 110 is composed of sixteen panels 112. In other examples, however, the roof 110 may be composed of a smaller or larger number of panels 112, including as few as a single panel 112. As will be discussed herein, the panels 112, or variants thereof, can be applied to a variety of vehicles in addition to the trailer 110. Examples of such vehicles include automobiles, vans, golf carts, buses, mobile homes, and the like.

The solar modules supported by the panels 112 are configured to generate electrical power for delivery to a power management assembly 116 of the vehicle 100. The power management assembly 116, as will be discussed further below, receives electrical power from the panels 112, and controls the delivery of electrical power to storage mechanisms such as batteries, external systems such as an electrical grid, onboard vehicle systems such as lighting, instrumentation and the like (e.g. a refrigeration or other temperature-control unit 118 shown on the trailer 108). The panels 112, as will be discussed in detail herein, include various structural features to support the solar modules and enable the delivery of electrical power generated thereby to the power management assembly 116.

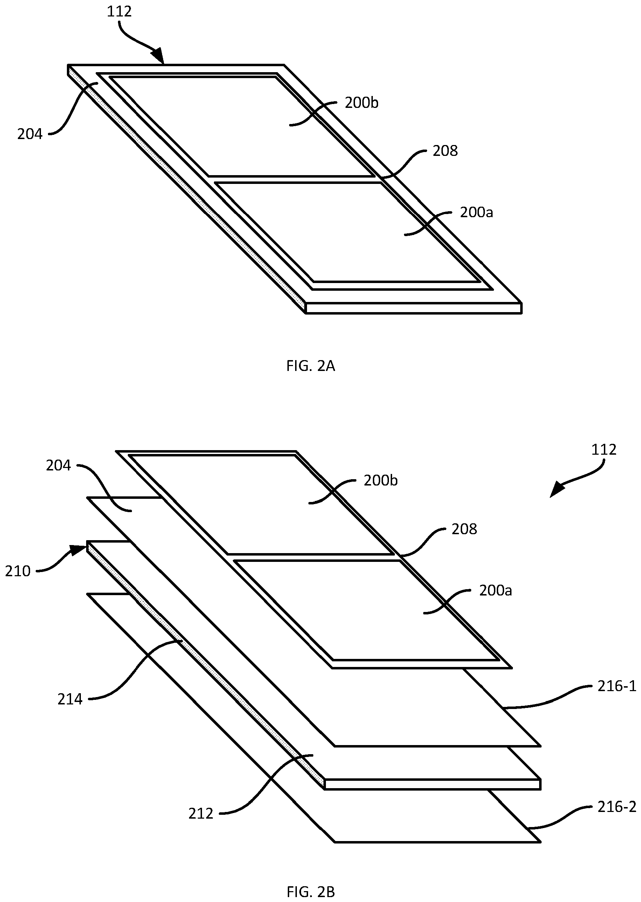

Turning to FIG. 2A, a panel 112 is shown in isolation. In particular, the panel 112 supports at least one flexible solar module 200 (e.g. a thin-film solar module) on an upper surface 204 thereof. The term "upper" refers to a direction facing from the roof 110 outwards from the vehicle 100 when the panel 112 is installed on the vehicle 100, with the vehicle 100 in an operational position. In other words, the term "upper" is used herein refers to a direction opposite to the direction of gravity. The term "lower" is employed herein to refer to the opposite direction (i.e. in the direction of gravity, towards the inside of the vehicle 100 from the roof 110).

In the present example, the panel 112 supports two modules 200a, 200b, provided on a common substrate 208 affixed to the upper surface 204. As will now be apparent, in other embodiments the panel 112 can support fewer than two modules 200, or more than two modules 200. In addition, the modules 200 need not be provided on the same substrate 208 as shown in FIG. 2A. As will be apparent to those skilled in the art, each module 200 includes electrical terminals (e.g. one positive terminal and one negative terminal) for connection to electrical conduits to carry electrical power generated by the module 200 toward the power management assembly 116. As will be discussed below, the panel 112 includes structural features for supporting the above-mentioned electrical conduits and connecting them between the terminals of each module 200 and the power management assembly 116.

Turning to FIG. 2B, an exploded view of the panel 112 is shown, with certain features of the panel 112 omitted for clarity, to be discussed below in connection with subsequent drawings. As shown in FIG. 2B, the panel 112 has a laminar structure defined by a core member 210 having an upper surface 212 and an opposing lower surface (not visible in FIG. 2B) separated by a perimeter 214. The panel 112 also includes an upper reinforcing skin member 216-1 and a lower reinforcing skin member 216-2. The skin member 216-1, as will now be apparent, defines the upper surface 204 of the panel 112, while the skin member 216-2 defines a lower surface of the panel 112 (facing the interior of the trailer 108, in the embodiment illustrated in FIG. 1).

The substrate 208 bearing the modules 200 is affixed to the upper skin member 216-1 (specifically, to the upper surface 204) via any suitable adhesive or other fastening material. The skin members 216, in turn, are affixed to the upper and lower surfaces, respectively, of the core member 210 via a suitable adhesive, which may be sprayed, rolled or the like, onto the core member 210 during manufacture of the panel 112. As illustrated, each of the skin members 216 extends over substantially the entirety of a corresponding surface of the core member 210. That is, the upper skin member 216-1 covers substantially the entirety of the upper surface 212 of the core member 210. The substrate 208 bearing the modules 200, meanwhile, need not cover the entirety of the upper surface 204. In some embodiments, however, the substrate 208 can cover the entirety of the upper surface 204.

The panel 112 has a generally rectangular shape in the illustrated example. The perimeter 214 of the core member 210 is thus a rectangular perimeter dividing the upper surface 212 from the lower surface of the core member 210. The perimeter 214, more specifically, includes a set (four, in the present example) of edges substantially perpendicular to the upper surface 212. In other examples, however, the panel 112 can take any of a variety of shapes, and therefore need not include a perimeter defined by pairs of parallel edges as shown in FIG. 2B.

The combination of the core member 210 and the skin members 216 provides the panel 112 with sufficient structural integrity to support the modules 200, as well as the weight of the panel 112 itself following installation (e.g. on the trailer 108). More specifically, the skin members 216 may provide bending resistance to the core member 210, while the core member 210 resists compressive loads. The core member 210 also, as will be discussed below in greater detail, supports and routes components such as electrical conduits connecting the modules 200 with other equipment, such as the power management assembly 116.

The core member 210 is fabricated from a composite material including at least a fiber and a binder. The fiber can include recycled materials (e.g. waste materials from other processes) such as rice husk, wood chips or fibers, carpet core and/or carcass, or the like. The fiber can also include, instead of or in addition to recycled materials, virgin materials (including any of the above-mentioned fibers). The fiber can include any suitable combination of natural and synthetic fibers; further examples of the fiber include nylon, polyethylene terephthalate (PET), polypropylene, and the like. The binder includes any of a variety of suitable binding agents, such as thermosetting polymers (e.g. polyurethane, polypropylene), thermoplastic polymers (e.g. polyvinyl chloride (PVC), polyethylene (PE)) and the like. The core member 200 can also include suitable additives, such as a foaming agent to reduce the density of the core member 210, stabilizing agents, coloring agents, fire retardants, and the like.

The skin members 216 are metallic in the present embodiment. In particular, each skin member 216 is a sheet of aluminum. In other embodiments, however, the skin members 216 can employ various other materials, including any one of, or any suitable combination of, steel (e.g. stainless steel, galvanized steel, painted steel and the like), aluminum, titanium, composites (e.g. a carbon fiber composite, Kevlar or the like) and the like. The skin members 216 can also include, in some embodiments, one or more coatings, e.g. to enhance binding of the above-mentioned adhesives, to inhibit corrosion, or the like. Further examples of the composition of the core member 210 and the skin members 216 may be found in Canadian Patent No. 2564406, the contents of which is incorporated herein by reference.

The panel 112 can have various configurations and sizes, based on the application for which the panel 112 is intended. In the example shown in FIG. 1, in which the panel 112 is one of a plurality of panels forming the roof 110 of the trailer 108, each panel 112 can include a core member 210 with a thickness (i.e. the dimension between the skin members 216) of about 4 mm to about 10 mm. The skin members 216 can each have a thickness of about 0.5 mm to about 2 mm. As will now be apparent to those skilled in the art, the panel 112 can be fabricated in a wide variety of other configurations, according to the dimensions and configuration of the vehicle 100.

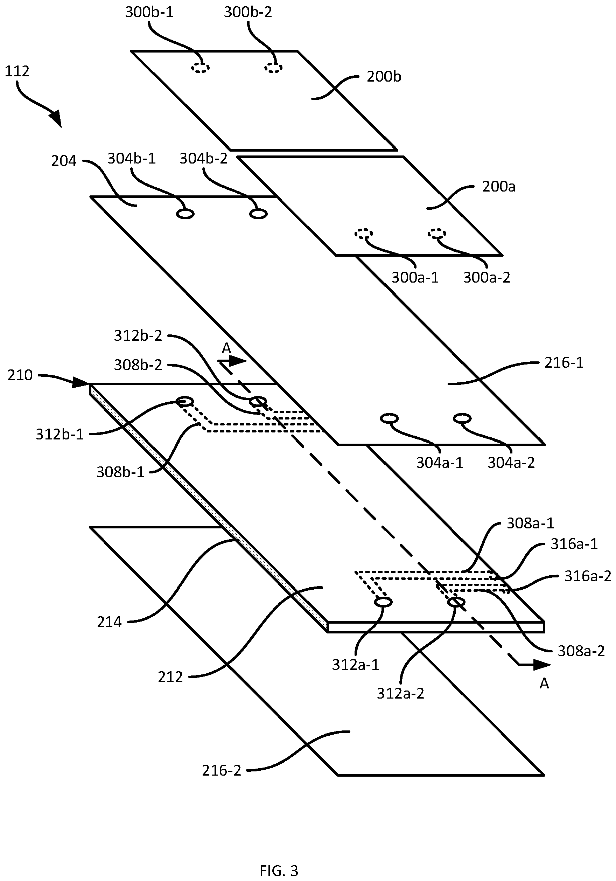

As noted above, the panel 112 also includes structural features enabling the panel 112 to support components such as electrical conduits associated with the modules Turning to FIG. 3, an exploded view of the panel 112 is shown, illustrating such structural features (omitted from FIG. 2B). In particular, as seen in FIG. 3, each module 200 includes terminals 300. In the present example, the module 200a includes a pair of terminals 300a-1 (e.g. a positive terminal) and 300a-2 (e.g. a negative terminal), while the module 200b includes a pair of terminals 300b-1 (e.g. a positive terminal) and 300b-2 (e.g. a negative terminal). The terminals 300 are configured to be connected to electrical conduits for transmitting electrical power generated by the corresponding module 200 towards the power management assembly 116, either directly or via other panels 112. That is, the modules 200 supported by a plurality of panels 112 (when the roof 110 includes a plurality of panels, as in FIG. 1) can be connected in series, in parallel, or in subcombinations thereof.

The upper skin member 216-1 includes at least one opening defined therethrough to expose at least one of the terminals 300 to the core member 210. In the present example, the upper skin member 216-1 includes an opening corresponding to each of the terminals 300. Therefore, the upper skin member 216-1 includes a first pair of openings 304a-1 and 304a-2 corresponding to the terminals 300a of the module 200a, and a second pair of openings 304b-1 and 304b-2 corresponding to the terminals 300b of the module 200b. In other examples, a single large opening can be provided, for example exposing both terminals 300b, rather than two distinct openings 304b-1, 304b-2.

In addition, the core member 210 includes at least one channel defined in the core material (e.g. the combination of a fiber and a binder as described above), between an upper channel outlet at the upper surface 212, and a lower channel outlet. In the present example, the core member 210 includes a pair of channels corresponding to each module 200. Thus, as shown in FIG. 3, the core member 210 includes channels 308a-1 and 308a-2 corresponding to the openings 304a. The channels 308a extend from upper channel outlets 312a-1, 312a-2 that are in communication with the openings 304a when the panel 112 is assembled. In other words, the terminals 300a are exposed to the interior of the channels 308a when the panel 112 is assembled. The channels 308a extend from the upper channel outlets 312a to lower channel outlets 316a. In the present example, the lower channel outlets 316a are formed in the perimeter 214 of the core member 210. In other examples, however, the lower channel outlets 316a can be defined in the lower surface of the core member 210, and the lower skin member 216-2 can include openings (e.g. similar to the openings 304 of the upper skin member 216-1) in communication with the lower channel outlets 316a. Similarly, the core member 210 also includes channels 308b-1, 308b-2 corresponding to the openings 304b and extending from upper channel outlets 312b1, 312b-2 to lower channel outlets (not visible in FIG. 3) defined in the perimeter 214.

In other examples, as with the openings 300, the channel outlets 312 and 316, as well as the channels 308 themselves, need not be separated as shown in FIG. 3. Instead, in some examples a single upper channel outlet 312, a single channel 308 and a single lower channel outlet 316 can be defined in the core member 210 for a given pair of terminals 300. The core member 210 can also include additional channels or cavities to contain additional components, such as a junction box connected to one or more modules 200. For example, either or both of the channels 308a (and/or either or both of the channels 308b) can include an enlarged portion containing a junction box.

The channels 308a and 308b are illustrated in FIG. 3 as being enclosed channels. That is, the channels 308a and 308b are enclosed between the upper surface 212 and the lower surface of the core member 210. In other examples, however, the channels 308a and 308b can be open to either of the upper surface 212 and the lower surface of the core member 210. In such embodiments, the channels 308 can be fabricated by routing to remove material from the core member 210. The channels 308 are then covered by the skin member 216-1 or 216-2 upon assembly of the panel 112.

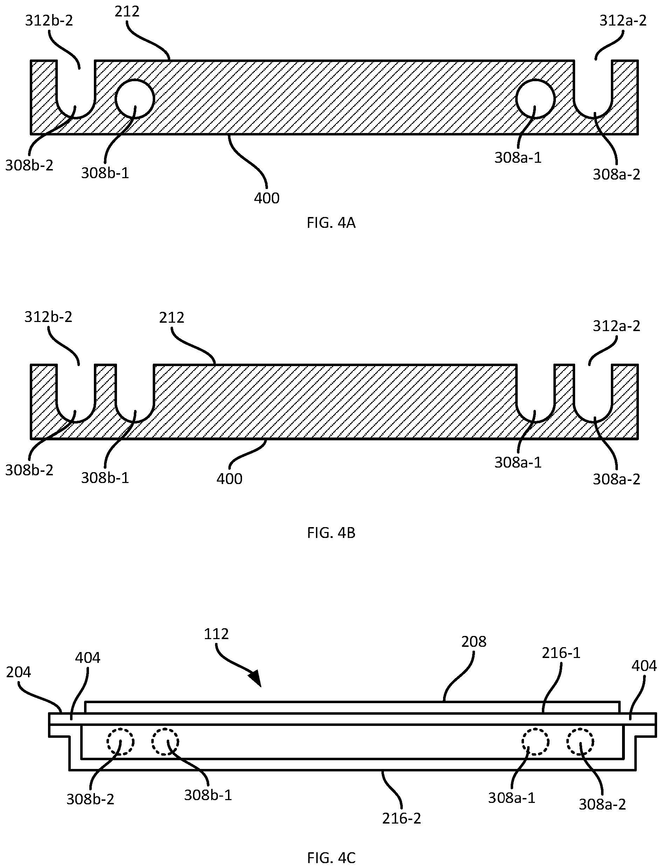

Turning to FIG. 4A, a cross section of the core member 210 is shown, taken at the line A-A in FIG. 3. As will be apparent to those skilled in the art, the core member 210 as shown in FIG. 4A is not shown to the same scale as in FIG. 3, to more clearly illustrate the aspects of the core member 210 discussed below. FIG. 4A illustrates the core member 210 as shown in FIG. 3, in which the channels 308 are enclosed. That is, the upper channel outlets 312a-1 and 312b-1 are not visible in FIG. 4A, and the channels 308 are substantially cylindrical channels travelling between the upper surface 212 and a lower surface 400 of the core member 210. FIG. 4B illustrates the core member 210 according to another embodiment, in which the channels 308 are open, such that the channels 308 are exposed at the upper surface 212 along their entire lengths.

As will now be apparent, electrical conduits (e.g. cables) are installed in the channels 308 during assembly of the panel 112. For example, in the embodiment shown in FIG. 4B, the conduits can be laid in the channels 308 prior to application of the upper skin member 216-1, and connectors provided at each end of the conduits can be connected to the terminals 300 at one end, and to downstream equipment such as the power management assembly 116 at the other end (or to other panels 112, as will be discussed below).

The panel 112 can also include one or more mounting members, for connecting the panel 112 to the vehicle 100. In particular, in the example shown in FIG. 1, each panel 112 includes mounting members for connecting the panel 112 to the walls of the trailer 108. Referring to FIG. 4C, a panel 112 is shown, in which the upper skin member 216-1 includes a flange 404 at either side thereof, for placement on the upper edge of a wall of the trailer 108 and fastening to the wall (e.g. via bolts, adhesives, or the like). The lower skin 216-2, in the embodiment shown in FIG. 4C, wraps around the edge of the core member 210 to meet the flange 404 of the upper skin 216-1. The flange 404 as well as the flanged portion of the lower skin 216-2 contacting the flange 404 can include openings for fasteners (e.g. bolts or the like) to fasten the panel 112 to the walls of the trailer 108 or the like.

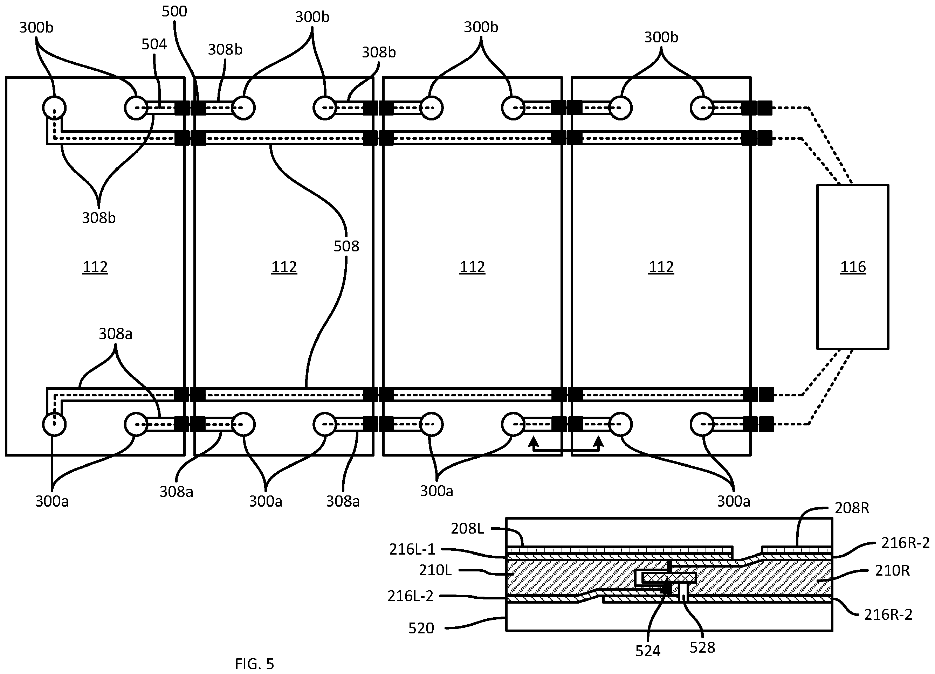

As noted earlier, the module(s) 200 of a given panel 112 can be connected directly to the power management assembly 116, or to the module(s) of another panel 112. FIG. 5 is a simplified illustration of a set of four panels 112, viewed from above, showing an example set of electrical conduits connecting the modules of the panels 112 to the power management assembly 116. In particular, the terminals 300a and 300b are illustrated (the modules 200 themselves are omitted), as are the channels 308a and 308b. The modules of the panels 112 are connected in two strings of four modules each. Specifically, the modules 200a of each panel 112 are connected in series in a first string, and the modules 200b of each panel 112 are connected in series in a second string.

Connectors 500 (e.g. Anderson connectors) disposed at each lower channel outlet 316 mate with corresponding connectors on the adjacent panel 112, to connect conduits 504 disposed in each channel 308. In addition, certain panels 112 include a bypass channel 508 in addition to the channels 308. The hot terminals of each panel 112 are connected to the neutral terminal of the adjacent panel, with the final hot terminal being connected to the power management assembly 116. The initial neutral terminal (of the leftmost panel 112) is also connected, via the bypass channels 508, to the power management assembly 116. Thus, each string of four modules shown in FIG. 5 is connected to the power management assembly 116 by a pair of conduits. In an example implementation such as that shown in FIG. 1, in which the roof 110 of the trailer 108 is defined by sixteen panels 112, the modules 200 are connected in four strings of eight modules 200, with the four pairs of output conduits being connected to the power management assembly 116. For example, the output conduits can travel through, or along a side of, one or more wall panels of the trailer 108 from the midpoint of the roof 110 (e.g. between the eighth and ninth panels 112) to connect to the power management assembly 116.

Various mechanisms are contemplated for joining the panels 112 together, e.g. in an assembly as shown in FIGS. 1 and 5. For example, the detail view 520 shown in FIG. 5 depicts a partial cross section taken at the line D-D, illustrating a joint between two panels 112. As shown in the detail view 520, the skin members 216-1 and 216-2 (referred to as 216L-1, 216L-2, 216R-1 and 216R-2 to distinguish the two panels shown in the detail view 520) define a shiplap joint. The panels 112 can also include mating components of a locking mechanism 524, such as a camlock, embedded in the core members 210L, 210R. The camlock can be operated (e.g. to switch between a locked and unlocked position by insertion of a tool (e.g. an allen key, screwdriver or the like) into an opening 528 defined through one of the skin members 216 and the core member 210.

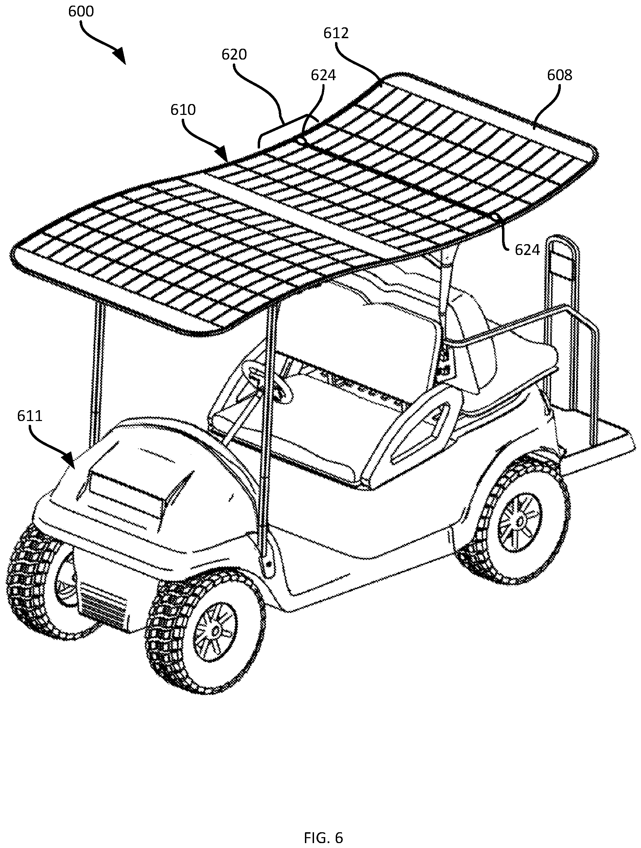

As noted earlier, the panel structure described above can be applied to a wide variety of other vehicles. Turning to FIG. 6, another embodiment is illustrated in which the panel structure is applied to a vehicle 600 such as a golf cart. The vehicle 600 includes a roof 610 supported by a body 611 of the vehicle 600, which contains a powertrain, energy storage (e.g. one or more batteries) and power management assembly (not shown). The roof 610, in the present example, is defined by a single panel 612 constructed substantially as described above in connection with the panel 112. The panel 612, however, differs in certain respects from the panel 112, as noted below.

The panel 612, as shown in FIG. 6, has a wave-shaped profile including a depressed region 620 with a lower elevation (relative to a ground surface when the vehicle 600 is in an operation position). The panel 612, in addition to the openings and channels discussed above in connection with the panel 112, also includes upper drainage openings 624, formed in either or both of the substrate 608 or the underlying upper skin member (when the substrate 608 is smaller in area than the upper skin member). The core member and the lower skin member of the panel 612 also include a drainage channel and a lower drainage opening, respectively, to allow fluid (e.g. rainwater) collected in the depressed region 620 to flow through the panel 612 and off the vehicle 600.

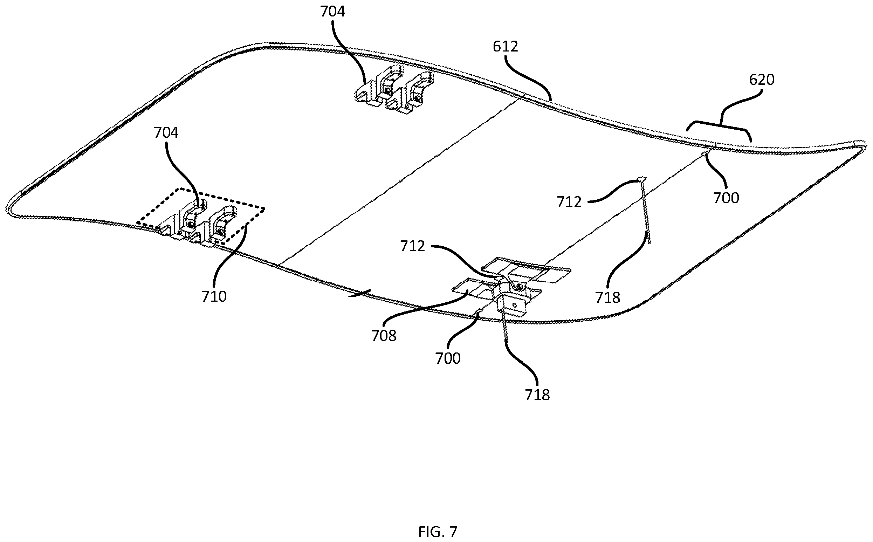

Turning to FIG. 7, the underside of the panel 612 is shown, with the remainder of the vehicle 600 omitted. Lower drainage openings 700, mentioned above, are visible in the depressed region 620. In addition, structural features of the panel 612 enabling mounting of the panel 612 to the vehicle 600 are illustrated in FIG. 7. In particular, rather than the flanges 404 discussed in connection with FIG. 4, the panel 612 includes brackets 704 configured for mounting to respective support posts of the body 611. In the present example, the panel 612 includes front brackets 704 and rear brackets 708. The brackets 704 and 708 can fastened to the panel 612 by bolts, screws, adhesives, or the like. In the present example, the panel 612 can include a reinforcing plate 710 embedded in the core member of the panel 612 and including threaded holes, nuts or the like for receiving bolts or other fasteners extending through the bracket 704, as well as the lower skin member of the panel 612. The panel 612 can also include such a reinforcing plate at the locations of the other brackets 704, 708.

One rear bracket 708 is omitted in FIG. 7 to more clearly illustrate the routing of electrical conduits of the panel 612. While the panel 112 includes lower channel outlets 316 defined in the perimeter 214, the lower channel outlets of the panel 612 are defined on the lower surface of the core member, and the lower skin member includes lower openings 712 through which electrical conduits 718 exit the panel 612, for connection to the power management assembly in the body 611 of the vehicle 600.

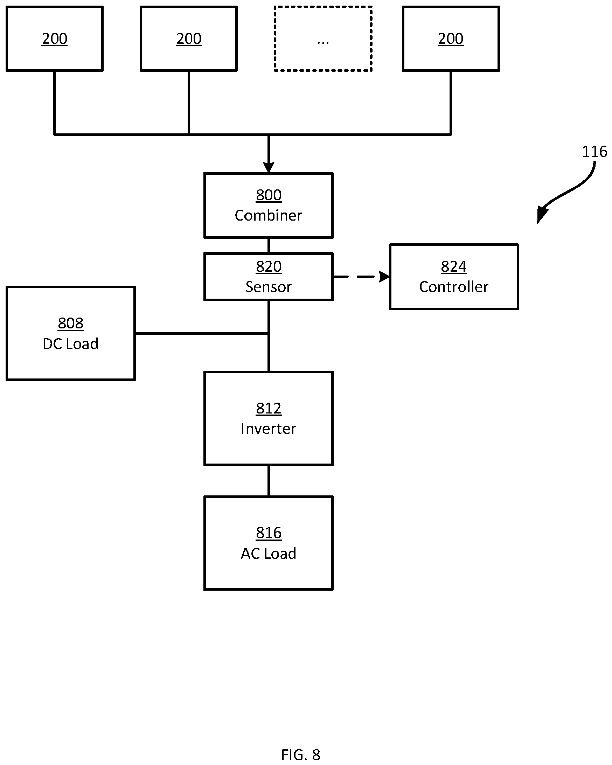

Turning to FIG. 8, a block diagram of the power management assembly 116 is shown. The power management assembly 116 includes a combiner 800 configured to receive as inputs the electrical conduits from the modules 200 (e.g. one pair of conduits per string of modules 200). The combiner 800, as will be apparent to those skilled in the art, is configured to generate a single output from the received inputs. The combiner 800, in some examples, is configurable to combine the inputs in parallel or in series, according to the requirements of the vehicle 100, 600 or external systems.

The output of the combiner 800 can be selectively directed by a switching mechanism to either of a DC load 808 (e.g. an onboard battery, or any other suitable DC-powered device) and an inverter 812 connected to an AC load 816. The nature of the AC load 816, as with the DC load 808, is not particularly limited. Examples of AC loads include external systems (e.g. a utility grid when the vehicle 100, 600 is stationary), onboard devices (e.g. the chiller 118, an electric powerplant of the vehicle 100, 600, and the like).

The power management assembly 116 can also include one or more sensors 820 connected to a controller 824 (e.g. a computing device), configured to measure electrical power generated by the modules 200. The controller 824 can be configured to collect and report such measurements to a further computing device, e.g. via a network (not shown).

The scope of the claims should not be limited by the embodiments set forth in the above examples, but should be given the broadest interpretation consistent with the description as a whole.

## Claims

1. A laminate panel for a vehicle, comprising:
a core member formed from a core material including a fiber and a binder, the core member having:
(i) a perimeter separating opposing upper and lower surfaces of the core member;
(ii) a channel defined in the core material between an upper channel outlet at the upper surface, and a lower channel outlet;
an upper reinforcing skin member affixed to the upper surface of the core member and defining an opening in communication with the upper channel outlet;
a flexible solar module affixed to the upper reinforcing skin member;
a lower reinforcing skin member affixed to the lower surface of the core member; and
an electrical conduit extending from the flexible solar module to the lower channel outlet via the opening, the upper channel outlet and the channel.

2. The laminate panel of claim 1, wherein the lower channel outlet is defined in the perimeter.

3. The laminate panel of claim 2, further comprising a releasable connector at the lower channel outlet.

4. The laminate panel of claim 1, wherein the lower channel outlet is defined in the lower surface of the core member; and
wherein the lower reinforcing skin member includes a lower opening in communication with the lower channel outlet.

5. The laminate panel of claim 1, wherein the channel is open at the upper surface of the core member.

6. The laminate panel of claim 1, wherein the channel is enclosed.

7. The laminate panel of claim 1, further comprising:
a second flexible solar module affixed to the upper reinforcing skin member; and
a second electrical conduit;
wherein the core member includes a second channel between a second upper channel outlet at the upper surface, and a second lower channel outlet;
wherein the upper reinforcing skin member includes a second opening in communication with the second channel.

8. The laminate panel of claim 1, wherein the upper reinforcing skin member includes a drainage inlet; wherein the core member includes a drainage channel in communication with the drainage inlet; and wherein the lower reinforcing skin member includes a drainage outlet in communication with the drainage channel.

9. The laminate panel of claim 8, wherein the drainage inlet is adjacent to the thin-film solar module.

10. The laminate panel of claim 8, wherein the upper reinforcing skin member has a wave-shaped profile.

11. A vehicle-mounted system for power generation, comprising:
at least one laminate panel including:
a core member formed from a core material including a fiber and a binder, the core member having:
(i) a perimeter separating opposing upper and lower surfaces of the core member;
(ii) a channel defined in the core material between an upper channel outlet at the upper surface, and a lower channel outlet;
an upper reinforcing skin member affixed to the upper surface of the core member and defining an opening in communication with the upper channel outlet;
a flexible solar module affixed to the upper reinforcing skin member; and
a lower reinforcing skin member affixed to the lower surface of the core member;
a power management assembly; and
an electrical conduit connecting the flexible solar module to the power management assembly via the opening, the upper channel outlet, the channel and the lower channel outlet.

12. The system of claim 11, wherein the power management assembly includes an inverter configured to receive electrical power via the electrical conduit, and to generate AC power for delivery to an AC load.

13. The system of claim 11, wherein the power management assembly is configured to direct DC power generated by the laminate panel to a DC load.

14. The system of claim 13, wherein the DC load includes one or more of an on-board vehicle system and a battery.

15. The system of claim 11, further comprising a plurality of additional laminate panels; wherein the flexible solar modules are connected in a set of strings; and
wherein the power management system includes a combiner configured to receive electrical power from each of the set of strings, and to combine the electrical power for output at a set of combiner terminals.

## Patentansprüche

1. Laminierte Platte für ein Fahrzeug, umfassend:
ein Kernbauteil, das aus einem Kernmaterial gebildet ist, das eine Faser und ein Bindemittel beinhaltet, wobei das Kernbauteil Folgendes aufweist:
(i) einen Umfang, der entgegengesetzte obere und untere Oberflächen des Kernbauteils trennt;
(ii) einen Kanal, der in dem Kernmaterial zwischen einem oberen Kanalauslass an der oberen Oberfläche und einem unteren Kanalauslass definiert ist;
ein oberes verstärkendes Hüllenbauteil, das an der oberen Oberfläche des Kernbauteils angebracht ist und eine Öffnung in Verbindung mit dem oberen Kanalauslass definiert;
ein flexibles Solarmodul, das an dem oberen verstärkenden Hüllenbauteil angebracht ist;
ein unteres verstärkendes Hüllenbauteil, das an der unteren Oberfläche des Kernbauteils angebracht ist; und
eine elektrische Leitung, die sich von dem flexiblen Solarmodul zu dem unteren Kanalauslass über die Öffnung, den oberen Kanalauslass und den Kanal erstreckt.

2. Laminierte Platte nach Anspruch 1, wobei der untere Kanalauslass in dem Umfang definiert ist.

3. Laminierte Platte nach Anspruch 2, weiter umfassend ein lösbares Verbindungsstück bei dem unteren Kanalauslass.

4. Laminierte Platte nach Anspruch 1, wobei der untere Kanalauslass in der unteren Oberfläche des Kernbauteils definiert ist; und
wobei das untere verstärkende Hüllenbauteil eine untere Öffnung in Verbindung mit dem unteren Kanalauslass beinhaltet.

5. Laminierte Platte nach Anspruch 1, wobei der Kanal an der oberen Oberfläche des Kernbauteils offen ist.

6. Laminierte Platte nach Anspruch 1, wobei der Kanal umschlossen ist.

7. Laminierte Platte nach Anspruch 1, weiter umfassend:
ein zweites flexibles Solarmodul, das an dem oberen verstärkenden Hüllenbauteil angebracht ist; und eine zweite elektrische Leitung;
wobei das Kernbauteil einen zweiten Kanal zwischen einem zweiten oberen Kanalauslass an der oberen Oberfläche und einen zweiten unteren Kanalauslass beinhaltet;
wobei das obere verstärkende Hüllenbauteil eine zweite Öffnung in Verbindung mit dem zweiten Kanal beinhaltet.

8. Laminierte Platte nach Anspruch 1, wobei das obere verstärkende Hüllenbauteil einen Ablaufeinlass beinhaltet; wobei das Kernbauteil einen Ablaufkanal in Verbindung mit dem Ablaufeinlass beinhaltet; und wobei das untere verstärkende Hüllenbauteil einen Ablaufauslass in Verbindung mit dem Ablaufkanal beinhaltet.

9. Laminierte Platte nach Anspruch 8, wobei der Ablaufeinlass an das Dünnfilmsolarmodul angrenzt.

10. Laminierte Platte nach Anspruch 8, wobei das obere verstärkende Hüllenbauteil ein wellenförmiges Profil aufweist.

11. Fahrzeugmontiertes System zur Stromerzeugung, umfassend:
zumindest eine laminierte Platte, die Folgendes beinhaltet:
ein Kernbauteil, das aus einem Kernmaterial gebildet ist, das eine Faser und ein Bindemittel beinhaltet, wobei das Kernbauteil Folgendes aufweist:
(i) einen Umfang, der entgegengesetzte obere und untere Oberflächen des Kernbauteils trennt;
(ii) einen Kanal, der in dem Kernmaterial zwischen einem oberen Kanalauslass an der oberen Oberfläche und einem unteren Kanalauslass definiert ist;
ein oberes verstärkendes Hüllenbauteil, das an der oberen Oberfläche des Kernbauteils angebracht ist und eine Öffnung in Verbindung mit dem oberen Kanalauslass definiert;
ein flexibles Solarmodul, das an dem oberen verstärkenden Hüllenbauteil angebracht ist; und
ein unteres verstärkendes Hüllenbauteil, das an der unteren Oberfläche des Kernbauteils angebracht ist;
eine Stromverwaltungsbaugruppe; und
eine elektrische Leitung, die das flexible Solarmodul mit der Stromverwaltungsbaugruppe über die Öffnung, den oberen Kanalauslass, den Kanal und den unteren Kanalauslass verbindet.

12. System nach Anspruch 11, wobei die Stromverwaltungsbaugruppe einen Wechselrichter beinhaltet, der dazu ausgelegt ist, elektrischen Strom über die elektrische Leitung zu empfangen und Wechselstrom zur Abgabe an einen Wechselstromabnehmer zu erzeugen.

13. System nach Anspruch 11, wobei die Stromverwaltungsbaugruppe dazu ausgelegt ist, Gleichstrom, der von der laminierten Platte erzeugt wird, an einen Gleichstromabnehmer zu richten.

14. System nach Anspruch 13, wobei der Gleichstromabnehmer eines oder mehreres von einem eingebauten Fahrzeugsystem und einer Batterie beinhaltet.

15. System nach Anspruch 11, weiter umfassend eine Vielzahl zusätzlicher laminierter Platten; wobei die flexiblen Solarmodule zu einem Satz von Strings verbunden sind; und
wobei das Stromverwaltungssystem einen Kombinierer beinhaltet, der dazu ausgelegt ist, elektrischen Strom von jedem des Satzes von Strings zu empfangen und den elektrischen Strom zur Abgabe bei einer Reihe von Kombiniereranschlüssen zu kombinieren.

## Revendications

1. Panneau stratifié pour un véhicule, comprenant :
un élément de noyau formé à partir d'un matériau de noyau incluant une fibre et un liant, l'élément de noyau présentant :
(i) un périmètre séparant des surfaces supérieure et inférieure opposées de l'élément de noyau ;
(ii) un canal défini dans le matériau de noyau entre une sortie de canal supérieure au niveau de la surface supérieure, et une sortie de canal inférieure ;
un élément de revêtement de renforcement supérieur fixé à la surface supérieure de l'élément de noyau et définissant une ouverture en communication avec la sortie de canal supérieure ;
un module solaire flexible fixé à l'élément de revêtement de renforcement supérieur ;
un élément de revêtement de renforcement inférieur fixé à la surface inférieure de l'élément de noyau ; et
un conduit électrique s'étendant du module solaire flexible à la sortie de canal inférieure par le biais de l'ouverture, de la sortie de canal supérieure et du canal.

2. Panneau stratifié selon la revendication 1, dans lequel la sortie de canal inférieure est définie dans le périmètre.

3. Panneau stratifié selon la revendication 2, comprenant en outre un connecteur libérable au niveau de la sortie de canal inférieure.

4. Panneau stratifié selon la revendication 1, dans lequel la sortie de canal inférieure est définie dans la surface inférieure de l'élément de noyau ; et
dans lequel l'élément de revêtement de renforcement inférieur inclut une ouverture inférieure en communication avec la sortie de canal inférieure.

5. Panneau stratifié selon la revendication 1, dans lequel le canal est ouvert au niveau de la surface supérieure de l'élément de noyau.

6. Panneau stratifié selon la revendication 1, dans lequel le canal est fermé.

7. Panneau stratifié selon la revendication 1, comprenant en outre :
un second module solaire flexible fixé à l'élément de revêtement de renforcement supérieur ; et un second conduit électrique ;
dans lequel l'élément de noyau inclut un second canal entre une seconde sortie de canal supérieure au niveau de la surface supérieure, et une seconde sortie de canal inférieure ;
dans lequel l'élément de revêtement de renforcement supérieur inclut une seconde ouverture en communication avec le second canal.

8. Panneau stratifié selon la revendication 1, dans lequel l'élément de revêtement de renforcement supérieur inclut une entrée de drainage ; dans lequel l'élément de noyau inclut un canal de drainage en communication avec l'entrée de drainage ; et dans lequel l'élément de revêtement de renforcement inférieur inclut une sortie de drainage en communication avec le canal de drainage.

9. Panneau stratifié selon la revendication 8, dans lequel l'entrée de drainage est adjacente au module solaire à couche mince.

10. Panneau stratifié selon la revendication 8, dans lequel l'élément de revêtement de renforcement supérieur présente un profilé en forme de vague.

11. Système monté sur un véhicule pour une génération d'énergie, comprenant :
au moins un panneau stratifié incluant :
un élément de noyau formé à partir d'un matériau de noyau incluant une fibre et un liant, l'élément de noyau présentant :
(i) un périmètre séparant des surfaces supérieure et inférieure opposées de l'élément de noyau ;
(ii) un canal défini dans le matériau de noyau entre une sortie de canal supérieure au niveau de la surface supérieure, et une sortie de canal inférieure ;
un élément de revêtement de renforcement supérieur fixé à la surface supérieure de l'élément de noyau et définissant une ouverture en communication avec la sortie de canal supérieure ;
un module solaire flexible fixé à l'élément de revêtement de renforcement supérieur ; et
un élément de revêtement de renforcement inférieur fixé à la surface inférieure de l'élément de noyau ;
un ensemble de gestion d'énergie ; et
un conduit électrique raccordant le module solaire flexible à l'ensemble de gestion d'énergie par l'intermédiaire de l'ouverture, de la sortie de canal supérieure, du canal et de la sortie de canal inférieure.

12. Système selon la revendication 11, dans lequel l'ensemble de gestion d'énergie inclut un onduleur configuré pour recevoir de l'énergie électrique par le biais du conduit électrique, et pour générer de l'énergie CA pour une fourniture à une charge CA.

13. Système selon la revendication 11, dans lequel l'ensemble de gestion d'énergie est configuré pour diriger de l'énergie CC générée par le panneau stratifié vers une charge CC.

14. Système selon la revendication 13, dans lequel la charge CC inclut un ou plusieurs parmi un système de véhicule embarqué et une batterie.

15. Système selon la revendication 11, comprenant en outre une pluralité de panneaux stratifiés supplémentaires ; dans lequel les modules solaires flexibles sont raccordés dans un ensemble de chaînes ; et
dans lequel le système de gestion d'énergie inclut un combinateur configuré pour recevoir de l'énergie électrique depuis chacune de l'ensemble de chaînes, et pour combiner l'énergie électrique pour une sortie au niveau d'un ensemble de terminaux de combinateur.
